# EUROPEAN PATENT APPLICATION

(11) **EP 0 825 651 A2**
(43) Date of publication of application: **25.02.1998**
(21) Application number: 97113435.8
(22) Date of filing: 04.08.1997
(51) Int. Cl.: H01L 27/146, H01L 31/0352

(54) **Monolithically integrated infrared detector circuits**

(30) Priority: 09.08.1996 IL 11904696
(71) Applicant: YEDA RESEARCH AND DEVELOPMENT CO. LTD., Rehovot 76100 (IL)
(72) Inventor: Meirav, Udi, Rehovot 76100 (IL); Bar-Joseph, Israel, Rehovot 76100 (IL); Heilblum, Mordehai, Rehovot 76100 (IL); Umansky, Vladimir, Rehovot 76262 (IL)
(74) Representative: Kraus, Walter, Dr.

(57) **Abstract**

This invention discloses a semiconductor chip comprising both a multi-pixel infra-red (IR) detector matrix and an electronic readout circuit associated with each pixel, which are vertically integrated within the same monocrystalline semiconductor chip.

## Description

### FIELD OF THE INVENTION

The present invention relates to infrared (IR) detectors generally.

### BACKGROUND OF THE INVENTION

IR detectors are of great importance for thermal imaging and night-vision, with applications ranging from military applications, such as night vision and weapon guidance to industrial, medical and possibly consumer product applications.

In order to produce an IR "picture", for example on a TV screen, one needs a large matrix of many elements, here termed pixels, each constituting a individual IR detector. Each such detector pixel translates incoming IR radiation into electronic signals and transfers the resulting information in an accurately synchronized way to a display or analysis system.

A matrix of this type is known as a Focal Plane Array (FPA). Each pixel in the FPA - there may be hundreds of thousands of pixels - must be separately connected to an independent electronic readout circuit, which transfers the pixel output signal to the display. Thus it may be appreciated that operation of an FPA requires a parallel matrix of readout circuits electrically connected to the matrix of detectors.

IR detectors are conventionally operated at low temperatures, usually at 77K. The IR detector itself is typically made of a suitable semiconductor, such as HgCdTe or InSb. Unfortunately these are not good materials for electronic applications, so the readout circuit cannot be made of the same material. The detectors and the readout circuits are thus incompatible, and an intricate network of electrical connections between two physically separated matrices is needed to realize a working FPA.

There are also known IR detecting elements based on a combination of layers of GaAs and AlGaAs, forming a sequence of "quantum wells" (QW). These QW infrared photodetectors, known as QWIPs, are specifically advantageous for FPAs due to the advanced stage of GaAs technology, providing high reliability and uniformity QWIP arrays. A further potential advantage of QWIPs, although not yet widely recognized as such, is that GaAs (unlike the other IR detector materials) is a semiconductor which is highly suitable for fabrication of electronic devices. This opens the possibility of full integration of the detector and readout on each pixel and the elimination of the complex interface between the two matrices.

Recently, considerable effort has been invested in the development of QWIP FPA technology. The associated read-out electronics is typically realized in a silicon chip using complementary metal-oxide-silicon (CMOS) technology, with an electrical and mechanical connection between the FPA chip and the CMOS readout. This development is described in the following reference:

L.J. Kozlowski *et al*. LWIR 128x128 GaAs/AlGaAs Multiple Quantum Well Hybrid Focal Plane Array. *IEEE Trans. Electron Devices*, vol.38no.5 1124-1130 (1991).

Such an approach suffers from several principal problems: hybrid integration, which in this case includes creation of pixel to pixel electrical contacts between two chips by direct mechanical contact using so called indium "bumps" as an intermediary conductor, is an expensive and not highly reliable process. Difference in thermal expansion coefficients often leads to a low process yield. Moreover, although CMOS technology is well developed for room temperature electronics, low temperature applications, such as IR detectors, require specially developed, and hence more expensive, CMOS chips which are able to operate at relevant temperatures.

The essential function of a readout circuit is to accumulate electric charge, generated by the detector, on a capacitor. This charge is accumulated over a certain time interval, and at the right instant is transferred from the capacitor, through an electronic switch, to the output. The quality of the capacitor is perhaps the most important aspect of the readout circuit; it must have the ability to store large amounts of charge without any of it "leaking" away. To store much charge it must have a relatively large area; but area is scarce due to the need to have hundreds of thousands of capacitors in a single array. To make matters worse, a relatively large area is also required by each detector element itself, so that it collects as much incoming IR radiation as possible.

The well known types of capacitors include metal-insulator-metal (MIM) and metal-insulator-semiconductor (MIS) capacitors. Since the metal layer can only be incorporated on the surface of the chip, integration of the detector, the capacitor and read-out transistor circuit can only be realized horizontally, namely side-by-side on the same pixel. This exacerbates the problem of chip "real estate" and constrains the capacitors to small areas. Such small area capacitors require higher voltages to store the same amount of charge which leads to increased leakage, noise and power consumption of the circuit.

GaAs based read-out technology has several well understood advantages over silicon CMOS electronics due to lower freeze-out temperatures, better radiation hardness and considerably higher speed. Several attempts have been made to evaluate GaAs read-out circuits. These attempts are described in the following publication:

L.J. Kozlowski, R.E. Kezer. 2x64 GaAs readout for IR FPA application. *SPIE vol. 1684 Infrared Readout Electronics*, p.131-138 (1992).

The absence of a reliable technology for fabricating MOS capacitors on GaAs yields additional problems. The first published GaAs read-out circuit, described in the above publication, used a 0.9 pF MIM capacitor, which is hard to implement in a monolithic FPA.

### SUMMARY OF THE INVENTION

The present invention seeks to provide a novel semiconductor structure which integrates in a single semiconductor chip both a multi-pixel infra-red (IR) detector matrix and an electronic readout circuit associated with each pixel.

The present invention overcomes the disadvantages of the existing techniques by fabricating a semiconductor structure in which all components of the IR detector and read-out circuit are vertically integrated within the same monocrystalline semiconductor chip. This is accomplished with a multiple-layer pixel comprising three levels: a QWIP detector, an semiconductor storage capacitor and a transistor circuit.

Each device level preferably is separated from the others by a semiconductor isolation layer. All elements in this structure are preferably made within an epitaxially grown, monocrystalline, semiconductor heterostructure using materials having differing band gaps. At present the most technologically developed material system is the combination of GaAs, AlAs and AlGaAs alloys.

Accordingly, it is an object of the present invention to provide a novel vertical monolithic integrated FPA which is much more efficient since both the detector and the capacitor elements each exploit substantially all of the pixel area.

It is a further object of the present invention to avoid expensive and low yield hybrid integration of infra-red detector and its read-out circuit.

Yet another object of the present invention is to implement a novel semiconductor capacitor allowing monolithic integration of FPA in a single monocrystal.

Additional objects and advantages of the present invention will become evident from the following description of a preferred embodiment of the invention taken in conjunction with the drawings.

There is also provided in accordance with a preferred embodiment of the present invention a semiconductor storage capacitor comprising three layers, each comprising a different semiconductor material.

Preferably, the semiconductor storage capacitor includes GaAs outer layers and a inner layer formed of either AlAs or AlGaAs.

### BRIEF DESCRIPTION OF THE DRAWINGS

The present invention will be understood and appreciated more fully from the following detailed description, taken in conjunction with the drawings in which:
Fig. 1 is a simplified illustration of a prior art equivalent circuit of one possible type of read-out electronic circuit, known as a Direct Injection (DI) circuit, connected to a IR detector;
Fig. 2 is a simplified cross sectional illustration of one pixel of a monolithic semiconductor chip constructed and operative in accordance with a preferred embodiment of the present invention; and
Fig. 3 is a simplified illustration showing interconnections between various layers inside the monolithic IR detector circuit forming part of the monolithic semiconductor chip of Fig. 2.

### DETAILED DESCRIPTION OF A PREFERRED EMBODIMENT

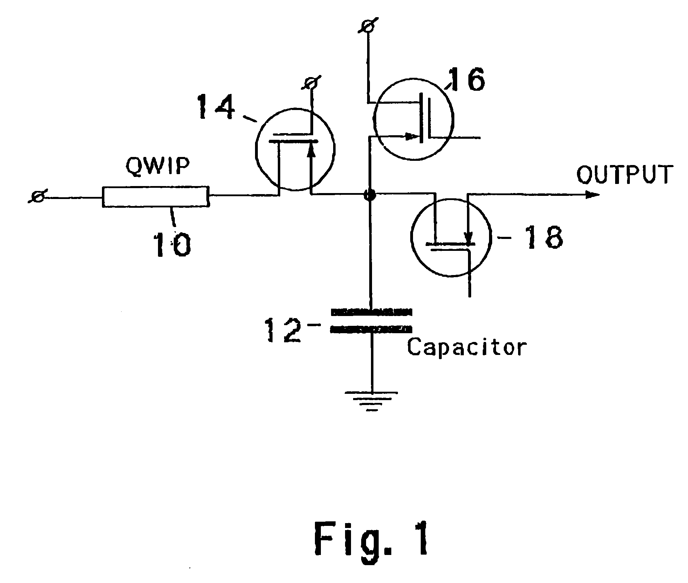

Reference is now made to Fig. 1, which illustrates a well known equivalent circuit of one type of read-out electronic circuit, known as a Direct Injection (DI) circuit, connected to an IR detector. The equivalent circuit includes a QWIP detector 10, a storage capacitor 12, a buffer transistor 14, a reset transistor 16 and a read-out transistor 18, whose functions will be described further below.

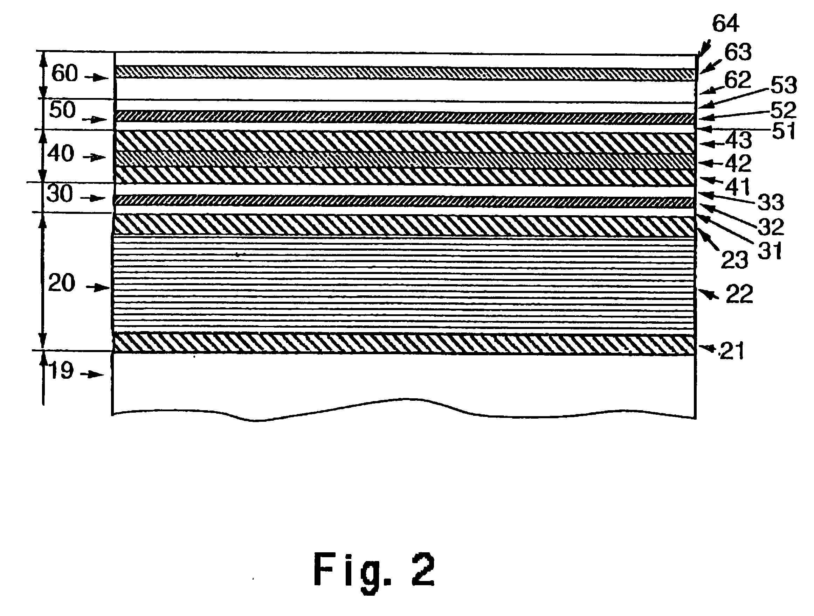

Reference is now made to Fig. 2, which is a simplified cross sectional illustration of one pixel of a monolithic semiconductor chip constructed and operative in accordance with a preferred embodiment of the present invention. The semiconductor heterostructure shown in Fig. 2 comprises the following layer groups, preferably epitaxially grown one on top of the other: a GaAs substrate 19, a QWIP structure 20 which is grown on the substrate 19, an isolation layer 30, a semiconductor capacitor 40, a second isolation layer 50, and a transistor structure 60. Each layer group of this structure includes specific sequence of semiconductor layers which enable its appropriate electrical function to be carried out.

The QWIP structure 20 and the transistor structure 60 are preferably fabricated using known technology. The QWIP structure 20 preferably has a known structure which includes a bottom contact GaAs n-type doped layer 21, a GaAs/AlGaAs superlattice 22 and a top contact GaAs n-type doped layer 23.

The transistor structure 60 may utilize any one of several known transistor designs. The illustrated example employs a high electron-mobility transistor (HEMT) structure, which includes an undoped GaAs "buffer" layer 62, an undoped AlGaAs "spacer" layer and an n-doped AlGaAs layer, both indicated by reference numeral 63, and a GaAs "cap" layer 64.

The novel semiconductor capacitor structure 40 preferably comprises an n-doped GaAs bottom contact layer 41, an undoped AlGaAs barrier layer 42 and a top contact n-doped GaAs layer 43. At low temperatures, typical of QWIP operation, the capacitor structure 40 described hereinabove has the ability to accumulate electron charge near the interface between the n-doped GaAs layer 41 and the AlGaAs barrier layer 42 when electrical current flows into the structure, or equivalently when voltage is applied between the contact layers. In other words, the device acts as a (parallel-plate) capacitor.

According to the present invention, isolation layer 30 includes an undoped GaAs bottom buffer layer 31, an undoped AlGaAs barrier 32 and an undoped GaAs top buffer layer 33. Similarly isolation layer 50 includes an undoped GaAs bottom buffer layer 51, an undoped AlGaAs barrier 52 and an undoped GaAs top buffer layer 53.

Isolation layers 30 and 50 have the property of being nonconductive at QWIP operation temperatures due to the potential barrier for electrons created by AlGaAs barrier layer. Thus the isolation layers 30 prevent unwanted electrical contact between the n-doped GaAs contact layer 23 and n-doped GaAs layer 41 and similarly, the isolation layer 50 prevents electrical contact between the n-doped GaAs layer 43 and the transistor structure 60 disposed thereabove.

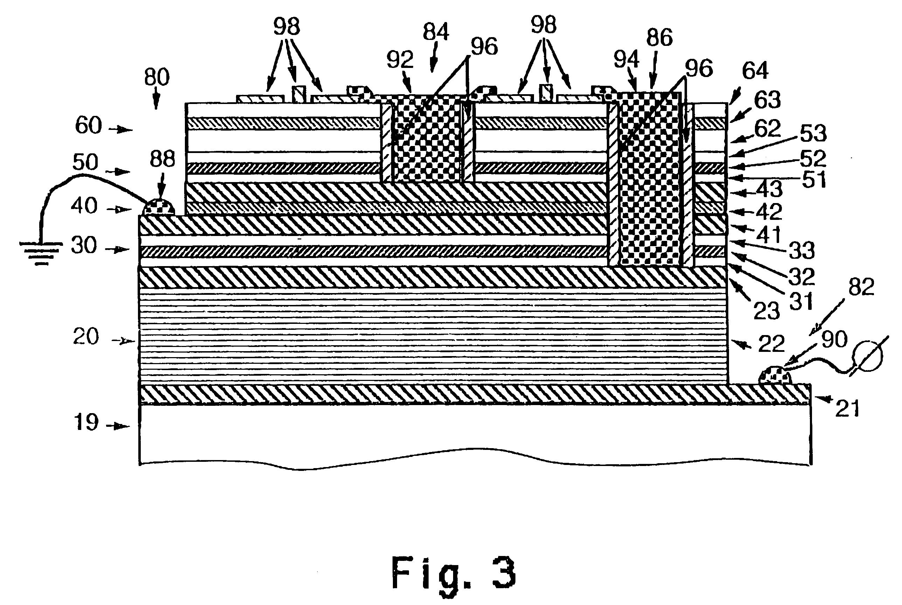

The structure described above may be epitaxially grown by any suitable technique, such as by any of the known technological methods, for instance Molecular Beam Epitaxy (MBE) or Chemical Vapor Deposition (CVD). After epitaxial growth, metal interconnects 92 and 94 between the various layers, as shown in Fig. 3, can be added by known lithographical and thin film deposition methods.

It may be seen that the structure of Fig. 3 incorporates the structure of Fig. 2, bearing the same reference numbers used in Fig. 2. A plurality of locations, here indicated generally by arrows 80, 82, 84 and 86, are etched by conventional techniques. Surface contacts 88 and 90 are attached to respective surfaces 41 and 21 at locations 80 and 82. At locations 84 and 86, metal filling, indicated by reference numerals 92 and 94 respectively with associated side wall electrical insulation 96 is provided in electrical contact with respective surfaces 43 and 23. Additional electrical contacts, such as those indicated by reference numeral 98, may also be provided on transistor layer 64.

In accordance with a preferred embodiment of the present invention, the monolithically integrated IR detector of Figs. 2 and 3 operates generally as follows: A bias voltage is applied to the bottom contact layer 21. When properly-polarized IR radiation impinges upon the QWIP structure 20, part of the radiation is absorbed while exciting electrons form the QW subbands, thus inducing a flow electrical current through the QWIP structure 20.

This current flows through the top contact layer 23 and via metal conductor 94 into the source of the buffer transistor 14 (Fig. 1). Referring now to Fig. 1, it is appreciated that the current continues through the output of transistor 14 to the capacitor 15. The capacitor collects the current signal during the integration time which is controlled by a external clock generator. At the end of the integration cycle, the read-out transistor 18 is switched on, connecting the integration capacitor 15 to the pixel output, thus forwarding the capacitor's charge (or voltage) signal for further processing. The reset transistor 16 is then switched on, rescuing the capacitor and enabling the cycle to start again.

It will be appreciated by persons skilled in the art that the present invention is not limited by what has been particularly shown and described hereinabove. Rather the scope of the present invention is defined only by the claims which follow:

## Claims

1. A semiconductor chip comprising both a multi-pixel infra-red (IR) detector matrix and an electronic readout circuit associated with each pixel, which are vertically integrated within the same monocrystalline semiconductor chip.

2. A semiconductor chip according to claim 1 and wherein said chip comprises:
a QWIP detector;
a semiconductor storage capacitor; and
a transistor circuit, said QWIP detector and semiconductor storage capacitor being each being located at a different one of first and second levels and said transistor circuit being located at a third level.

3. A semiconductor chip according to claim 2 and comprising an isolation layer disposed between said first level and said second level and an isolation layer disposed between said second level and said third level.

4. A semiconductor chip according to claim 1 which is produced with a epitaxially grown, semiconductor heterostructure.

5. A semiconductor chip according to claim 4 and wherein said semiconductor heterostructure is produced using materials having differing band gaps.

6. A semiconductor chip according to claim 4 or claim 5 and comprising a combination of GaAs, AlAs and AlGaAs alloys.

7. A semiconductor storage capacitor comprising three layers, each comprising a different semiconductor material.

8. A semiconductor storage capacitor according to claim 7 and wherein said three layers comprise GaAs outer layers and an inner layer formed of either AlAs or AlGaAs.
